# EUROPEAN PATENT SPECIFICATION

(11) **EP 2 587 175 B1**
(45) Date of publication and mention of the grant of the patent: **17.06.2015**
(21) Application number: 12190581.4
(22) Date of filing: 30.10.2012
(51) Int. Cl.: F24F 1/00, H05K 7/20, F24F 13/20, F24F 13/32, F24F 13/08

(54) **Fan supporting structure for climate control machines with underfloor air flow**
Lüfterträgerstruktur für Klimaregelmaschinen mit Unterbodenluftstrom
Structure de support de ventilateur pour machines de climatisation avec un écoulement d'air sous plancher

(30) Priority: 31.10.2011 IT PD20110342
(43) Date of publication of application: 01.05.2013
(73) Proprietor: Emerson Network Power S.R.L., 35028 Piove di Sacco (PD) (IT)
(72) Inventor: Barbato, Pierpaolo, 35027 Noventa Padovana PD (IT)
(74) Representative: Modiano, Micaela Nadia

(56) References cited:
- US-A1- 2009 129 913
- US-A1- 2010 041 327

## Description

The present invention relates to a fan supporting structure for climate control machines with underfloor air flow.

Server rooms, and in general any site that contains numerous electronic devices and racks for supporting a plurality of servers, electric and electronic instruments and the like, generally enclosed within adapted ventilated cabinets, require continuous climate control that is adapted to prevent the heat originating from the computers and from the electronic instruments themselves from accumulating and thus causing temperatures that are so high as to damage the internal components of such electronic instruments and the like.

Nowadays, in order to overcome these drawbacks, floor climate control plants are generally installed in server rooms, and are increasingly widespread particularly in environments installed on a raised floor (see for example patent document US-2010041327-A which discloses a fan supporting structure according to the preamble of claim 1).

In fact the space between the ground and the raised floor can be easily fitted out not only for the distribution of cables for connecting and powering the racks and computers, but also as a plenum space, i.e. as an area for the passage of conditioned air, fed in by one or more cooling and climate control machines, such plenum spaces conveying the air, by way of floor grilles, either to the overlying environment or directly into the rack cabinets.

Machines for such climate control are generally constituted by a cabinet within which heat exchange means are arranged below which there are, generally arranged below the raised floor, a plurality of fans which are designed to aspirate air from the upper part of the cabinet so that it crosses the heat exchange means and is then pushed, treated, into the underfloor space.

The fans, of the centrifugal type, are generally two or more in number, and are supported by an open frame within a single compartment, thus with no bulkhead or partition between two adjacent fans.

Such technical solution, although widespread, does not make it possible to obtain the maximum efficiency from the fans.

In fact, at the point of minimum distance between two adjacent fans, the high speed air flows meet in opposite directions, causing strong turbulence; thus there is an impairment of the performance of the two fans because owing to the turbulence it is not possible to recover part of the kinetic energy supplied by the fans, and moreover the noise is increased for the same air flow.

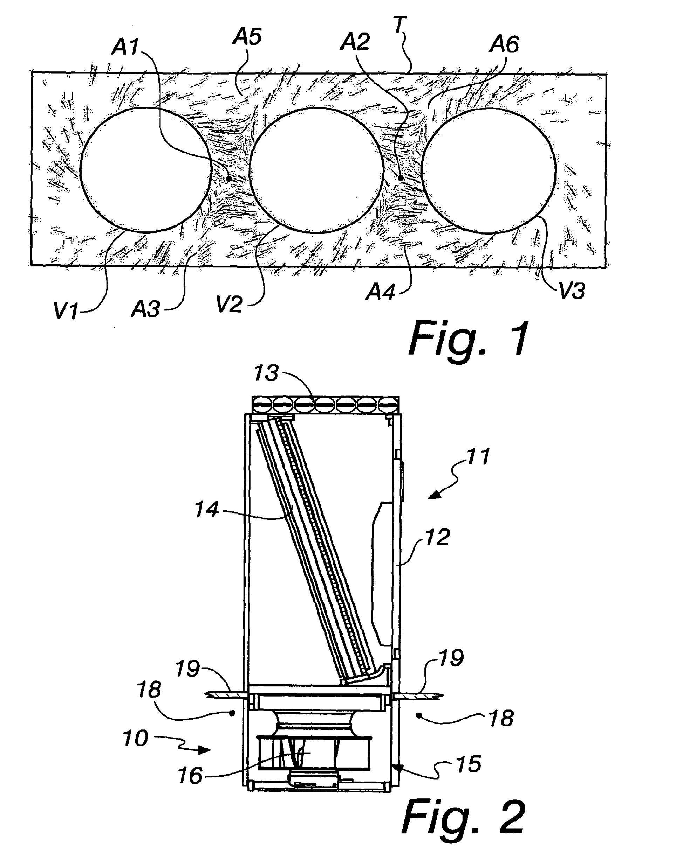

This is exemplified in Figure 1, which schematically shows a generic fan supporting frame T with three fans V1, V2 and V3 within it.

The arrows show the directions of the air flows exiting from the fans.

In the intermediate regions between two fans, A1 and A2 in Figure 1, the flows are substantially opposite and mutually contrast each other, with the result that in the outflow zones A3, A4, A5 and A6 the flow arrows are fairly thinly spread and oriented with a highly accentuated angle, so as to indicate a low exit speed and a strong redirection of the flow.

It has been shown that the interposition of a flat partition between two fans has not achieved the hoped-for and desired ameliorative effects.

The aim of the present invention is to provide a fan supporting structure for climate control machines with underfloor air flow which is capable of overcoming the above-mentioned drawback of the known art.

Within this aim, an object of the invention is to provide a fan supporting structure that makes it possible to reduce the turbulence between two adjacent fans and optimize the performance levels thereof.

Another object of the invention is to provide a fan supporting structure which can be installed easily even on conventional underfloor climate control machines already in use.

Another object of the invention is to provide a fan supporting structure for climate control machines with underfloor air flow which can be produced using known systems and technologies.

This aim and these and other objects which will become more apparent hereinafter are all achieved by a fan supporting structure for climate control machines with underfloor air flow, said climate control machines comprising a cabinet with one or more air intake grilles, inside which there are heat exchange means below which, supported by a corresponding supporting frame, there are two or more fans adapted to draw air from the overlying cabinet and to propel it into the space below a raised floor, said fan supporting structure being characterized in that a partition is interposed on said supporting frame between two adjacent fans and has a substantially S-shaped profile with respect to a sectional plane that is perpendicular to the rotation axis of a fan and is designed to divide the air flows among the fans and guide them toward the outside of the supporting frame.

Further characteristics and advantages of the invention will become more apparent from the description of a preferred, but not exclusive, embodiment of the fan supporting structure according to the invention, which is illustrated by way of non-limiting example in the accompanying drawings wherein:
Figure 1 is a schematic view of the pattern of air flows between fans in the known art;
Figure 2 is a schematic side view of a climate control machine comprising a fan supporting structure according to the invention;
Figure 3 is a perspective view of the fan supporting structure according to the invention, associated with a climate control machine;
Figure 4 is a sectional view from above of a fan supporting structure according to the invention;
Figure 5 is a front perspective view of the fan supporting structure according to the invention;
Figure 6 is a schematic view of the pattern of air flows between fans which are arranged in a fan supporting structure according to the invention.

With reference to the figures, a fan supporting structure for climate control machines with underfloor air flow is generally designated with the reference numeral 10.

A generic climate control machine is designated with the reference numeral 11; it comprises a cabinet 12 with one or more air intake grilles, for example a grille 13, inside which there are heat exchange means 14, which obviously are understood to be of a conventional type, for example with a tubiform bank and fins, below which there are, supported by a corresponding supporting frame 15, two or more fans (in the present descriptive example there are three fans, designated with 16, 17 and 17a).

Such fans 16, 17 and 17a are adapted to draw air from the overlying cabinet 12 and to propel it into the space 18 under a raised floor 19.

On the supporting frame 15, between two adjacent fans, for example 16 and 17, but in an identical manner between the two fans 17 and 17a, a partition 20 is interposed which has a substantially S-shaped profile with respect to a sectional plane that is perpendicular to the rotation axis of a fan and is designed to divide the air flows among the fans and guide them toward the outside of the supporting frame 15.

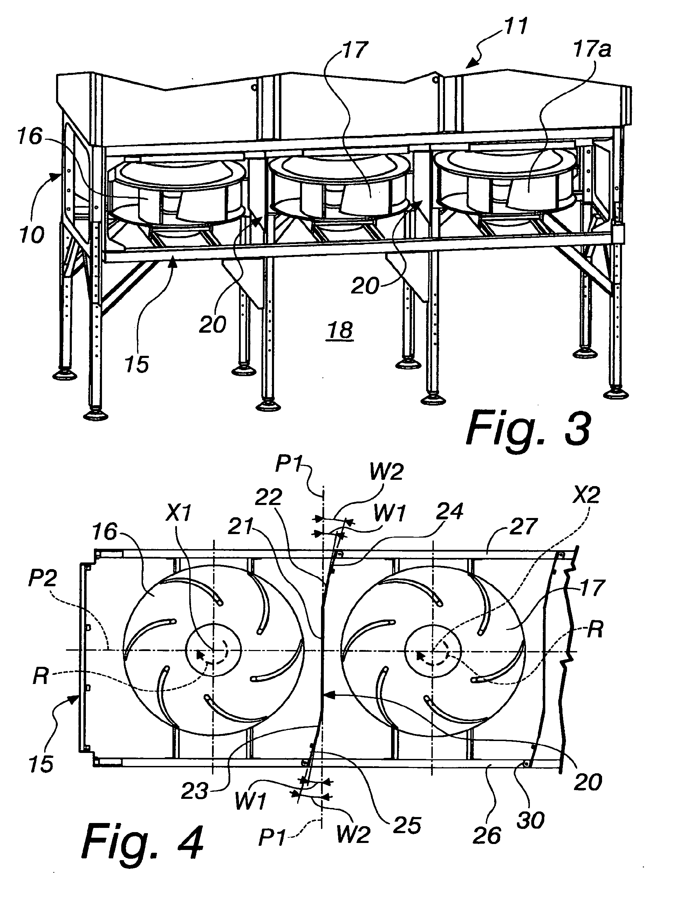

As can clearly be seen in Figure 4, such partition 20 has
- a central portion 21 which lies on a first plane P1 which is substantially perpendicular to a plane P2 that passes through the rotation axes X1 and X2 of two laterally adjacent fans 16 and 17 in Figure 4;
- and two axially symmetrical opposite redirection portions 22 and 23, which are inclined by an angle W1 measured from the first plane P1 and extending in the direction of rotation R of the fans.

Each one of the redirection portions 22 and 23 of the partition 20 also has an end portion, 24 and 25 respectively, which is further inclined by a second angle W2 with respect to the first plane P1 and in the direction of rotation R of the fans.

The second angle W2 is larger than the first angle W1.

The first angle W1 is comprised between 5° and 15°, and is preferably approximately 10°, whereas the second angle W2 is comprised between 10° and the 20°, and is preferably approximately 15°.

The partition 20 is constituted by a folded metal sheet.

Such partition 20 is fixed to the opposing longitudinal members 26, 27 and 28 and 29 of the supporting frame 15 by way of threaded couplings or other similar and equivalent means.

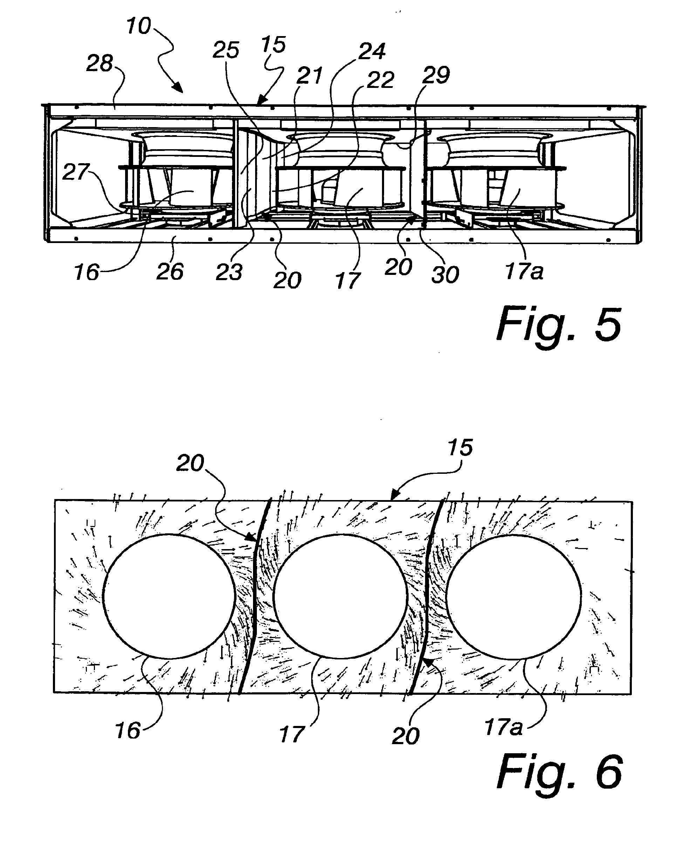

The screws lock corresponding folded tabs 30 which are provided on the metal sheet partition, as in Figures 4 and 5.

The schematic image in Figure 6 shows how the adoption of the partitions 20, thus dividing the air flows and orienting them, diminishes the turbulence between two adjacent fans and increases the exit speed of the air from the frame 15.

In practice it has been found that the invention fully achieves the intended aim and objects.

In fact, with the invention a fan supporting structure for climate control machines with underfloor air flow is provided which makes it possible to reduce the turbulence between two adjacent fans and optimize the performance levels thereof.

What is more, with the invention a fan supporting structure is provided which can be installed easily even on conventional underfloor climate control machines already in use.

In addition, with the invention a fan supporting structure for climate control machines with underfloor air flow is provided which can be produced using known systems and technologies.

The invention, thus conceived, is susceptible of numerous modifications and variations, all of which are within the scope of the appended claims. Moreover, all the details may be substituted by other, technically equivalent elements.

In practice the materials employed, provided they are compatible with the specific use, and the contingent dimensions and shapes, may be any according to requirements and to the state of the art.

Where technical features mentioned in any claim are followed by reference signs, such reference signs have been inserted for the sole purpose of increasing the intelligibility of the claims and accordingly such reference signs do not have any limiting effect on the interpretation of each element identified by way of example by such reference signs.

The disclosures in Italian Patent Application No. PD2011A000342 from which this application claims priority are incorporated herein by reference.

Where the technical features mentioned in any claim are followed by reference numerals and/or signs, those reference numerals and/or signs have been included for the sole purpose of increasing the intelligibility of the claims and accordingly, such reference numerals and/or signs do not have any limiting effect on the interpretation of each element identified by way of example by such reference numerals and/or signs.

## Claims

1. A fan supporting structure (10) for climate control machines with underfloor air flow, said climate control machines (11) comprising a cabinet (12) with one or more air intake grilles (13), inside which there are heat exchange means (14) below which, supported by a corresponding supporting frame (15), there are two or more fans (16, 17) adapted to draw air from the overlying cabinet and to propel it into the space (18) below a raised floor (19), said fan supporting structure comprising a partition (20) interposed on said supporting frame (15) between two adjacent fans (16, 17) and being **characterized in that** it has a substantially S-shaped profile with respect to a sectional plane that is perpendicular to the rotation axis of a fan and is designed to divide the air flows among the fans and guide them toward the outside of the supporting frame (15).

2. The fan supporting structure according to claim 1, **characterized in that** said partition (20) has
- a central portion (21) which lies on a first plane (P1) which is substantially perpendicular to a plane (P2) that passes through the rotation axes (X1, X2) of two laterally adjacent fans,
- at least two axially symmetrical opposite redirection portions (22, 23), which are inclined by an angle (W1) measured from said first plane (P1) and extending in the direction of rotation (R) of the fans.

3. The fan supporting structure according to claim 2, **characterized in that** one of each of the redirection portions (22, 23) of the partition (20) has an end portion (24, 25) which is further inclined by a second angle (W2) with respect to said first plane (P1) and in the direction of rotation (R) of the fans.

4. The fan supporting structure according to claim 3, **characterized in that** said second angle (W2) is greater than said first angle (W1).

5. The fan supporting structure according to one or more of the preceding claims, **characterized in that** said first angle (W1) is comprised between 5° and 15° and is preferably approximately 10°, said second angle (W2) being comprised between 10° and 20° and being preferably approximately 15°.

6. The fan supporting structure according to one or more of the preceding claims, **characterized in that** said partition (20) is constituted by a folded metal sheet.

7. The fan supporting structure according to one or more of the preceding claims, **characterized in that** said partition (20) is fixed to the opposite longitudinal members (26, 27, 28, 29) of the supporting frame (15) by means of threaded couplings or other similar and equivalent means.

## Patentansprüche

1. Eine Lüfterträgerstruktur (10) für Klimaregelmaschinen mit Unterbodenluftstrom, wobei die Klimaregelmaschinen (11) ein Gehäuse (12) mit einem oder mehreren Lufteinlassgittern (13) umfassen, in dem sich Wärmetauschmittel (14) befinden und darunter zwei oder mehrere von einem entsprechenden Stützrahmen (15) getragene Lüfter (16, 17) dazu ausgebildet sind, Luft aus dem darüber liegenden Gehäuse anzusaugen und in den Bereich (18) unterhalb eines Doppelbodens (19) zu befördern, wobei die Lüfterträgerstruktur eine Trennwand (20) umfasst, die am Stützrahmen (15) zwischen zwei nahe beieinander liegenden Lüftern (16, 17) angeordnet ist, **dadurch gekennzeichnet, dass** sie ein im Wesentlichen S-förmiges Profil in Bezug auf eine Schnittebene hat, die senkrecht zur Drehachse eines Lüfters ist, und dazu ausgebildet ist, die Luftströme zwischen den Lüftern zu trennen und außerhalb des Stützrahmens (15) zu leiten.

2. Die Lüfterträgerstruktur gemäß Anspruch 1, **dadurch gekennzeichnet, dass** die Trennwand (20) Folgendes aufweist:
- einen zentralen Abschritt (21), der auf einer ersten Ebene (P1) liegt, welcher im Wesentlichen senkrecht zu einer Ebene (P2) ist, die durch die Drehachsen (X1, X2) zweier nebeneinanderliegender Lüfter verläuft,
- mindestens zwei gegenüberliegende axialsymmetrische Umleitungsabschnitte (22, 23), die um einen von der ersten Ebene (P1) aus gemessenen Winkel (W1) geneigt sind und sich in Drehrichtung (R) der Lüfter erstrecken.

3. Die Lüfterträgerstruktur gemäß Anspruch 2, **dadurch gekennzeichnet, dass** jeder der Umleitungsabschnitte (22, 23) der Trennwand (20) einen Endabschnitt (24, 25) aufweist, der weiter um einen zweiten Winkel (W2) gegenüber der ersten Ebene (P1) und in Drehrichtung (R) der Lüfter geneigt ist.

4. Die Lüfterträgerstruktur gemäß Anspruch 3, **dadurch gekennzeichnet, dass** der zweite Winkel (W2) größer als der erste Winkel (W1) ist.

5. Die Lüfterträgerstruktur gemäß einem oder mehreren der vorhergehenden Ansprüche, **dadurch gekennzeichnet, dass** der erste Winkel (W1) zwischen 5° und 15° liegt und vorzugsweise ungefähr 10° beträgt, wobei der zweite Winkel (W2) zwischen 10° und 20° liegt und vorzugsweise ungefähr 15° beträgt.

6. Die Lüfterträgerstruktur gemäß einem oder mehreren der vorhergehenden Ansprüche, **dadurch gekennzeichnet, dass** die Trennwand (20) aus gefalztem Blech besteht.

7. Die Lüfterträgerstruktur gemäß einem oder mehreren der vorhergehenden Ansprüche, **dadurch gekennzeichnet, dass** die Trennwand (20) an den gegenüberliegenden Längsträgern (26, 27, 28, 29) des Stützrahmens (15) mithilfe von mit Gewinde versehenen Verbindungselementen oder anderen ähnlichen und gleichwertigen Mitteln befestigt ist.

## Revendications

1. Structure de support de ventilateur (10) pour machines de climatisation avec un écoulement d'air sous le plancher, lesdites machines de climatisation (11) comprenant une armoire (12) avec une ou plusieurs grilles d'admission d'air (13), à l'intérieur desquelles se trouvent des moyens d'échange de chaleur (14), au-dessous desquels, supportés par un châssis de support (15) correspondant, on trouve deux ventilateurs (16, 17) ou plus, adaptés pour aspirer l'air de l'armoire sousjacente et pour le propulser dans l'espace (18) au-dessous d'un plancher relevé (19), ladite structure de support de ventilateur comprenant une séparation (20) intercalée sur ledit châssis de support (15) entre deux ventilateurs (16, 17) adjacents et **caractérisée en ce qu'**elle a un profil sensiblement en forme de S par rapport à un plan de section qui est perpendiculaire à l'axe de rotation d'un ventilateur et est conçu pour diviser les écoulements d'air parmi les ventilateurs et les guider vers l'extérieur du châssis de support (15).

2. Structure de support de ventilateur selon la revendication 1, **caractérisée en ce que** ladite séparation (20) a :
une partie centrale (21) qui se trouve sur un premier plan (P1) qui est sensiblement perpendiculaire à un plan (P2) qui passe par les axes de rotation (X1, X2) de deux ventilateurs latéralement adjacents,
au moins deux parties de redirection (22, 23) opposées axialement symétriques, qui sont inclinées selon un angle (W1) mesuré à partir dudit premier plan (P1) et s'étendant dans la direction de rotation (R) des ventilateurs.

3. Structure de support de ventilateur selon la revendication 2, **caractérisée en ce que** l'une de chacune des parties de redirection (22, 23) de la séparation (20) a une partie d'extrémité (24, 25) qui est en outre inclinée par un second angle (W2) par rapport audit premier plan (P1) et dans la direction de rotation (R) des ventilateurs.

4. Structure de support de ventilateur selon la revendication 3, **caractérisée en ce que** ledit second angle (W2) est supérieur audit premier angle (W1).

5. Structure de support de ventilateur selon une ou plusieurs des revendications précédentes, **caractérisée en ce que** ledit premier angle (W1) est compris entre 5° et 15° et est de préférence d'approximativement 10°, ledit second angle (W2) étant compris entre 10° et 20° et étant de préférence d'approximativement 15°.

6. Structure de support de ventilateur selon une ou plusieurs des revendications précédentes, **caractérisée en ce que** ladite séparation (20) est constituée par une feuille de métal pliée.

7. Structure de support de ventilateur selon une ou plusieurs des revendications précédentes, **caractérisée en ce que** ladite séparation (20) est fixée aux éléments longitudinaux (26, 27, 28, 29) opposés du châssis de support (15) au moyen de couplages filetés ou d'autres moyens similaires et équivalents.
